Europäisches Patentamt

European Patent Office

Office européen des brevets

(19)

(11) Veröffentlichungsnummer: **0 085 198**
**B1**

(12) **EUROPÄISCHE PATENTSCHRIFT**

(45) Veröffentlichungstag der Patentschrift:
**22.05.85**

(21) Anmeldenummer: **82201288.6**

(22) Anmeldetag: **18.10.82**

(51) Int. Cl.⁴: **H 05 K 1/09, H 04 Q 7/00**

(54) **Elektronisches Gerät mit mittels Ranglerbrücken festgelegter Arbeitsweise.**

(30) Priorität: **02.02.82 CH 617/82**

(43) Veröffentlichungstag der Anmeldung:
**10.08.83 Patentblatt 83/32**

(45) Bekanntmachung des Hinweises auf die Patenterteilung:
**22.05.85 Patentblatt 85/21**

(84) Benannte Vertragsstaaten:
**AT BE CH DE FR GB IT LI LU NL**

(56) Entgegenhaltungen:
**CH - A - 583 485**
**DE - A - 3 017 238**
**FR - A - 2 414 274**
**GB - A - 2 071 425**

(73) Patentinhaber: **Autophon A.G., Ziegelmattstrasse 1-15,
CH-4500 Solothurn 3 (CH)**

(72) Erfinder: **Friedli, Christian, Kronmattstrasse 17,
CH-4513 Langendorf (CH)**

(74) Vertreter: **Schweizer, Hans et al, Bovard AG
Patentanwälte VSP Optingenstrasse 16,
CH-3000 Bern 25 (CH)**

EP 0 085 198 B1

## Beschreibung

Die vorliegende Erfindung betrifft ein elektronisches Gerät mit einer Arbeitsweise, welche mittels Rangierbrücken festgelegt und bei Bedarf veränderbar ist. Ein solches Gerät ist beispielsweise der in der CH-PS Nr. 583485 beschriebene Rufempfänger, bei welchem der dem Anruf dieses Empfängers dienende Kode durch geeignetes Einlegen von Rangierbrücken verändert werden kann. Es ist dabei allgemein üblich, Schalter anzuordnen oder die zu verbindenden Punkte als Federn, Klemmen, Stecker, Steckerbuchsen, Lötösen oder sonstige Löt- oder Kontaktpunkte auszubilden und die notwendigen Brücken durch Einlegen, Einstecken, Auf- oder Einschrauben oder durch Einlöten anzubringen.

Sofern die Geräte gross sind, stehen alle die genannten Möglichkeiten offen. Schraub- und Steckverbindungen sind zwar aufwendiger als Lötverbindungen, bieten aber den Vorteil, dass sie ohne besondere Werkzeuge und Fachkenntnisse eingelegt oder geändert werden können. Bei kleinen Geräten, z.B. Taschengeräten, drängen sich Lötverbindungen auf, deren Fertigung wegen der Platzverhältnisse jedoch viel Geschick erfordert.

Die vorliegende Erfindung löst die Aufgabe, auch in kleinen Geräten Rangierbrücken ohne Hilfe von besonderen Werkzeugen und ohne besondere Anforderungen an die Geschicklichkeit einzulegen und gegebenenfalls wiederum zu entfernen. Dabei wird von der Erkenntnis ausgegangen, dass in elektronischen Schaltungen, im Gegensatz zu elektromechanischen, der Widerstandswert für die Brücken auch von praktisch Null abweichen kann. Dies ist möglich, weil es in den meisten Schaltungen, in denen Rangierbrücken in Frage kommen, genügt, wenn in diesen Brücken Ströme von wenigen Mikroamperen fliessen.

Die vorliegende Erfindung geht nun von dieser Erkenntnis aus. Sie betrifft ein elektronisches Gerät der eingangs genannten Art, in welchem die Brücken zwischen den Enden von festen, auf einer Leiterplatte angebrachten Leitern verlaufen. Dieses Gerät ist dadurch gekennzeichnet, dass die Brücken durch einen zwischen den zu verbindenden Enden auf die Leiterplatte aufgetragenen, selbst haftenden und elektrisch leitenden Stoff gebildet sind.

In einem bevorzugten Ausführungsbeispiel besteht die Leiterplatte aus Keramik, und die Leiter sind nach der Methode der Dickfilmschaltungen darauf aufgebracht. Die zu verbindenden Enden der Leiter sind ungefähr 0,5 mm voneinander entfernt, und die Verbindung wird mit einem gewöhnlichen weichen Bleistift (Graphitstift) hergestellt. Dank der rauhen Oberfläche der Platte haftet die Bleistiftspur gut daran, und die dabei auftretenden Widerstandswerte liegen zwischen 100 $\Omega$ und 10 k$\Omega$ gegenüber Werten in der Grössenordnung von 100 M$\Omega$ ohne angebrachte Verbindung. Bei der Aufhebung einer solchen Verbindung durch einen gewöhnlichen Radiergummi können die ursprünglichen Isolationswerte ohne weiteres wiederum erreicht werden.

Anstelle einer Keramikleiterplatte kann auch eine gewöhnliche Leiterplatte zusammen mit einem Bleistift verwendet werden, sofern sie vorher z.B. durch Sandstrahlen aufgerauht wird. Anstelle eines Bleistifts ist auch die Verwendung von leitender Tinte denkbar, welche mit einer Feder, einem Pinsel oder einem Stempel aufgebracht wird. Sofern ein leitender Klebstoff verwendet wird, können auch Leiterplatten mit glatter Oberfläche verwendet werden.

Die Erfindung ist natürlich nicht auf Rufempfänger beschränkt. Sie kann auch für Kode- und Rufnummerngeber aller Art angewendet werden sowie für Steueranlagen, welche universell einsatzfähig sein müssen, deren Programm aber selten geändert wird.

## Patentansprüche

1. Elektronisches Gerät mit mittels Rangierbrücken festgelegter, bei Bedarf veränderbarer Arbeitsweise, wobei die Brücken zwischen den Enden von festen, auf einer Leiterplatte angebrachten Leitern verlaufen, dadurch gekennzeichnet, dass die Brücken durch einen zwischen den zu verbindenden Enden auf die Leiterplatte aufgetragenen, selbst haftenden und elektrisch leitenden Stoff gebildet sind.

2. Elektronisches Gerät nach Anspruch 1, dadurch gekennzeichnet, dass die Brücken mit Hilfe eines Bleistifts (Graphitstifts) aufgetragen sind.

3. Elektronisches Gerät nach Anspruch 1, dadurch gekennzeichnet, dass die genannte Leiterplatte aus keramischem Material besteht, auf welches die festen Leiter nach der Methode der sogenannten Dickfilmschaltungen aufgebracht sind.

## Claims

1. Electronic apparatus having a mode of operation established by means of straps and variable in case of need, the straps running between the ends of fixed conductors affixed to a circuit board, characterized in that the straps are formed by a self-adhering and electrically conductive substance applied to the circuit board between the ends to be connected.

2. Electronic apparatus according to Claim 1, characterized in that the straps are applied with the aid of a lead pencil (graphite pencil).

3. Electronic apparatus according to Claim 1, characterized in that the said circuit board consists of ceramic material to which the fixed conductors are applied according to the method of the so-called thick-film circuits.

## Revendications

1. Appareil électronique avec mode d'opération établi par des barrettes de pontage et pouvant être modifié selon les nécessités, les barrettes s'étendant entre les extrémités de conducteurs fixes disposés sur une plaque de conducteurs, caractérisé en ce que les barrettes de pontage sont formées par une substance auto-adhésive et électriquement conductrice appliquée sur la plaque de conducteurs entre les extrémités à relier.

2. Appareil électronique selon la revendication 1, caractérisé en ce que les barrettes de pontage sont appliquées à l'aide d'un crayon (mine de graphite).

3. Appareil électronique selon la revendication 1, caractérisé en ce que ladite plaque de conducteurs consiste en un matériau céramique sur lequel les conducteurs fixes sont appliqués par la méthode dite des circuits en films épais.